# EUROPEAN PATENT SPECIFICATION

(11) **EP 3 908 932 B1**
(45) Date of publication and mention of the grant of the patent: **05.04.2023**
(21) Application number: 20706454.4
(22) Date of filing: 19.02.2020
(51) Int. Cl.: G06F 11/18, G06F 11/07, G06F 11/14

(54) **TOPOLOGY-DRIVEN BYZANTINE FAULT-TOLERANT CONSENSUS PROTOCOL WITH VOTE AGGREGATION**
TOPOLOGIEBASIERTES BYZANTINISCHES FEHLTERTOLERANTES KONSENSPROTOKOLL MIT ABSTIMMUNGSAGGREGATION
PROTOCOLE DE CONSENSUS À TOLÉRANCE DE FAUTES BYZANTINES BASÉ SUR LA TOPOLOGIE ET POURVU D'UNE AGGRÉGATION DE VOTE

(30) Priority: 14.10.2019 EP 19203048
(43) Date of publication of application: 17.11.2021
(73) Proprietor: NEC Corporation, Tokyo 108-8001 (JP)
(72) Inventor: FEDOROV, Sergey, 69221 Dossenheim (DE)
(74) Representative: Ullrich & Naumann PartG mbB
(86) International application number: PCT/EP2020/054357
(87) International publication number: WO 2021/073777

(56) References cited:
- EP-A1- 3 499 787
- US-A1- 2019 251 077
- US-A1- 2019 286 531
- JIAN LIU ET AL: "Scalable Byzantine Consensus via Hardware-assisted Secret Sharing", ARXIV.ORG, CORNELL UNIVERSITY LIBRARY, 201 OLIN LIBRARY CORNELL UNIVERSITY ITHACA, NY 14853, 15 December 2016 (2016-12-15), XP081423257, DOI: 10.1109/TC.2018.2860009 cited in the application

## Description

The present invention relates to Byzantine Fault-Tolerant (BFT) consensus protocols and also to distributed ledger technologies. More specifically, the present invention relates to a method for establishing consensus between a plurality of distributed nodes connected via a data communication network, the plurality of distributed nodes including a plurality of active nodes, the plurality of active nodes including a leader node.

Permissioned distributed ledger technologies have recently attracted great attention due to their possible applications in a wide range of industrial use cases. At its core, a distributed ledger system relies on a notion of agreement, or consensus, to ensure consistency of the replicated data. For that purpose, Byzantine fault-tolerant (BFT) voting-based consensus protocols provide desirable properties in terms of resilience and finality of agreement. However, such protocols suffer from high computational and communication overhead.

This motivated researchers and practitioners to devise new BFT consensus protocols that aim at achieving high scalability and performance in practical deployments. For instance, FastBFT protocol (as described in Jian Liu, Wenting Li, Ghassan Karame, N. Asokan: "Scalable Byzantine Consensus via Hardware-assisted Secret Sharing", in IEEE Transaction on Computers, 2019) 81423257, is a good example that employs such optimizations as hardware-assisted secret sharing for vote aggregation, combined with passive replication and advanced communication topologies, to achieve high throughput with low latency. As another example, CheapBFT protocol (as described in R. Kapitza, J. Behl, C. Cachin, T. Distler, S. Kuhnle, S. V. Mohammadi, W. Schröder-Preikschat, and K. Stengel: "CheapBFT: resource-efficient byzantine fault tolerance', in Proceedings of the 7th ACM European conference on Computer Systems, 2012) employs a subset of those optimizations, namely passive replication and trusted hardware assistance.

Known leader-based BFT consensus protocols commonly include a special mechanism, called view change, to handle possible faults of the leader node. In addition, protocols optimized with passive replication typically use another, more conservative, consensus protocol to handle certain non-leader fault scenarios. In that case, a special transition mechanism is invoked to abort the failed consensus round and prepare the system for switching into the fallback protocol.

Document US-A1-2019/0286531 discloses improved consensus mechanisms including techniques for achieving consensus among network nodes in a distributed system, performing a change of primary node in a distributed system, and performing a recovery process for a network node in a distributed system.

It is therefore an object of the present invention to improve and further develop a method of the initially described type for establishing consensus between a plurality of distributed nodes in such a way that the implementation complexity is reduced, thereby facilitating verification for correctness.

The present invention provides a method for establishing consensus between a plurality of distributed nodes connected via a data communication network, the plurality of distributed nodes including a plurality of active nodes, the plurality of active nodes including a leader node, each of the plurality of distributed nodes including a processor and computer readable media. The method includes executing, by the leader node, preparing a proposal; constructing a first communication topology by organizing the plurality of active nodes into a tree structure, rooted in the leader node; and propagating the proposal to active nodes according to the first communication topology. The method further includes, by the leader node, in case of receiving any sufficient set of vote aggregations from the active nodes, creating a proposal commitment using the vote aggregations and accepting the proposal, or, in case of suspecting that the first communication topology is not reliable to reach consensus on the proposal due to active node faults, creating an updated communication topology different from the first communication topology, propagating the same proposal down to active nodes according to the updated communication topology, and deferring a creation of a commitment binding that includes binding of a proposal to an aggregation of votes of active nodes until after the leader node has aggregated any sufficient quorum of votes to reach consensus on the proposal.

Furthermore, the present invention provides a computer readable medium having stored thereon instructions for carrying out such a method for establishing consensus between a plurality of distributed nodes connected via a data communication network.

The invention is defined in the appended independent method claim 1 and medium claim 14.

Embodiments of the invention provide a method for establishing consensus between the plurality of distributed nodes by means of a novel Byzantine fault-tolerant consensus protocol that does not require complicated mechanisms to tolerate non-leader faults while employing advanced optimization techniques such as passive replication, advanced communication topologies, and vote aggregation. As an extension to state of art optimized consensus protocols, embodiments of the invention allow to eliminate complicated mechanisms to tolerate non-leader faults, such as fallback and transition sub-protocols, while preserving the same core set of advanced optimization techniques. This allows for a simpler consensus protocol implementation that is easier to verify for correctness, as desired for a critical component of a distributed ledger technology.

The present invention relates to a method for topology-driven fault-tolerant consensus with vote aggregation. The method comrpises step of beginning, by a leader node, a consensus round on a proposal using an optimistic communication topology (which is the first communication topology in the terminology of the present disclosure). The leader node may terminate the consensus round based on the first communication topology. Alternatively, in case of suspected faults of one or more active non-leader nodes, the leader node switches to an updated communication topology and resumes the consensus round using this new (updated) communication topology. According to an embodiment, the update may include an elimination/replacement of the active nodes from the first communication topology, which were suspected to behave faulty, i.e. the set of active nodes might change when updating the communication topology.

This process, i.e. switching from a current communication topology to an updated communication topology, may be repeated in each case of suspected fault of active non-leader node. According to an embodiment, a threshold specifying a maximum number of allowed repetitions may be applied. The thresholds may be preconfigured or may be determined during operation according to a given algorithm.

Once the threshold is reached, i.e. the leader node has executed the maximum number of consensus rounds with different optimistic communication topologies, the leader node may fall back into using a pessimistic reliable communication topology (which is the fallback communication topology in the terminology of the present disclosure) and resume the consensus round using this fallback communication topology. Basically, this means that in case a given number of optimistic communication topologies are suspected not reliable for reaching consensus, the leader node switches into using a fallback topology. Like in the case of communication topology updates, the set of active nodes might change when switching into a fallback topology. It should be noted that switches into using a fallback topology is in contrast to prior art solutions that, instead of using a fallback topology, perform transitioning into a fallback protocol, which, however, makes the entire process more complicated.

According to an embodiment, active non-leader nodes vote for the leader node's proposal, aggregate received expected valid vote aggregations, if any, with own vote, and communicate the aggregation up, according to the communication topology.

According to the invention, the leader node binds the proposal to a vote aggregation and communicates the binding combined with the aggregation to other nodes after aggregated any sufficient quorum of votes. In order to further simplify the protocol, it is provided that the leader node defers binding of a proposal to an aggregation of votes until after it has aggregated any sufficient quorum of votes. Active and passive nodes may accept a proposal once obtained a valid sufficient vote aggregation as well as a valid binding of the proposal to the aggregation.

Basically, the consensus protocol disclosed herein only improves the handling of faults of non-leader active nodes. Therefore, in accordance with embodiments of the invention, in case of a leader fault, a special mechanism, known as view change, may be implemented to construct a state machine replication protocol.

There are several ways how to design and further develop the teaching of the present invention in an advantageous way. To this end it is to be referred to the dependent patent claims on the one hand and to the following explanation of preferred embodiments of the invention by way of example, illustrated by the figure on the other hand. In connection with the explanation of the preferred embodiments of the invention by the aid of the figure, generally preferred embodiments and further developments of the teaching will be explained. In the drawing the only
- Fig. 1: is a flow diagram illustrating a processing procedure executed at a leader node according to an embodiment of the invention,
- Fig. 2: is a flow diagram illustrating a processing procedure executed at an active node according to an embodiment of the invention,
- Fig. 3: is a flow diagram illustrating a processing procedure executed at a passive node according to an embodiment of the invention,
- Fig. 4: depicts a network including a plurality of distributed nodes with an optimized communication topology according to an embodiment of the invention, and
- Fig. 5: depicts a network including a plurality of distributed nodes with a fallback communication topology according to an embodiment of the invention.

Recent interest in blockchain technology has given fresh impetus for developing and improving BFT protocols. A blockchain is a key enabler for distributed consensus, serving as a public ledger for digital currencies (e.g., Bitcoin) and other applications. Bitcoin's blockchain relies on the well-known proof-of-work (PoW) mechanism to ensure probabilistic consistency guarantees on the order and correctness of transactions. It is a great success to have PoW regulate the transaction order agreement among thousands of nodes, which cannot be achieved by conventional BFT protocols due to the limitation of the communication complexity. However, Bitcoin's PoW has been severely criticized for its considerable waste of energy and meagre transaction throughput (~7 transactions per second).

To remedy these limitations, there are several proposals to make the traditional BFT protocols, which are excellent in terms of transaction throughput with dozens of nodes, more scalable to handle consensus for thousands of participating nodes. MinBFT (described in G. S. Veronese, M. Correia, A. Neves Bessani, L. C. Lung and P. Verissimo, "Efficient byzantine fault-tolerance," in IEEE Transactions on Computers, 2013) and CheapBFT, (described in R. Kapitza, S. Johannes Behl, C. Cachin, T. Distler, S. Kuhnle, S. V. Mohammadi, W. Schröder-Preikschat and K. Stengel, "CheapBFT: resource-efficient byzantine fault tolerance," in Proceedings of the 7th ACM european conference on Computer Systems, 2012) first propose to use TEE (Trusted Execution Environment) to reduce the total number of peers from 3f+1 to 2f+1, where f is the number of tolerated faulty nodes. However, the communication complexity still remains to be O(n²), which prevents the network from scaling up to hundreds of nodes. Cosi (described in E. Syta, I. Tamas, D. Visher, D. Isaac Wolinsky, P. Jovanovic, L. Gasser, N. Gailly, I. Khoffi and B. Ford, "Keeping authorities" honest or bust" with decentralized witness cosigning," in Security and Privacy, 2016) leverages tree structure and signature aggregation to reduce the communication complexity to O(n), but using public signature on each node is expensive and the system still requires 3f+1 nodes. FastBFT (described in J. Liu, W. Li, G. O. Karame and N. Asokan, Scalable Byzantine Consensus via Hardware-assisted Secret Sharing, arXiv preprint arXiv:1612.04997, 2016) combines TEE with an efficient message aggregation technique based on secret-sharing to achieve a more efficient protocol using only 2f+1 nodes.

However, the mentioned leader-based BFT consensus protocols commonly invoke rather complicated mechanisms in terms of handling possible faults of non-leader nodes. Embodiments of the invention, applied to certain optimized BFT consensus protocols, contribute to further optimization, in terms of reducing implementation complexity. Being a critical mechanism, consensus protocol implementation will benefit from the reduced complexity, so that it becomes more simple and easier to verify for correctness.

Embodiments of the invention provide a mechanism for a number of distributed computational nodes, connected by a data communication network, to reach consensus on a *proposal.* The proposal refers, or is *bound,* to a *proposal payload.* In one possible embodiment, the payload may represent a sequence of transactions to be added to a distributed ledger. In another possible embodiment, the payload may represent a sequence of operations to be performed by a replicated state machine.

According to embodiments, the plurality of distributed nodes connected via a data communication network are supposed to execute a common piece of algorithm, called *consensus algorithm.* Those nodes that are correctly executing the consensus algorithm are called *correct* nodes. The remaining nodes are called *faulty* nodes*.* The number of faulty node is assumed to have a known upper bound. The consensus is established among correct nodes by agreeing on and *accepting* the proposal, according to the algorithm.

In some embodiments, a node can be provided with a *trusted execution environment (TEE).* Herein, a TEE is defined as an isolated computational environment, together with strictly defined mechanisms to interact with it. TEE provides a certain level of guarantee for correct execution of the code running within the TEE, preserving the code's integrity as well as integrity and confidentiality of the data processed by the code. An isolated instance of such protected code and data is referred to herein as *trusted application.*

In different embodiments, depending on the desired level of isolation, TEE can be provided by a dedicated hardware device (e.g. Trusted Platform Module), CPU feature (e.g. Intel^{®} SGX or ARM TrustZone), virtualization technology (e.g. XEN or KVM), OS kernel (e.g. Linux Containers or OS processes), or even purely in application software (e.g. using secure modular programming techniques).

According to embodiments of the invention, the proposal is prepared by a designated node called the *leader* node. The proposal may include a unique *proposal identifier* that distinguishes it from any other proposal.

According to embodiments of the invention, the leader node selects a subset of nodes according to a predefined algorithm, e.g. randomly. The leader node together with the selected nodes are called *active* nodes. The additional nodes are called *passive* nodes. Active non-leader nodes can *vote* for the proposal to be accepted. The vote refers, or is *bound*, to the corresponding proposal identifier. The votes that are bound to the same proposal identifier can be combined, or *aggregated*, into a more compact representation called (partial) *vote aggregation.* For convenience, a single vote can be considered as a simple vote aggregation solely consisting of that vote.

According to embodiments, once the leader node has collected a set of vote aggregations that represents a sufficient number of votes produced by different active nodes, it obtains a *commitment vote aggregation* by further aggregating the collected vote aggregations. Then the leader node *binds* the corresponding proposal to the commitment vote aggregation to obtain a *commitment binding.* After that, the leader node creates a *proposal commitment* that includes the commitment binding together with the corresponding vote aggregation. Given a valid proposal commitment, active and passive nodes can safely accept the corresponding proposal.

Applied to a BFT consensus protocol optimized with passive replication and optimistic communication topology, embodiment of the invention allows to *resume* a consensus round, interrupted due to a suspected active node fault, with an updated communication topology. Falling back to using a pessimistic, but reliable, communication topology eliminates the need for a distinct fallback protocol.

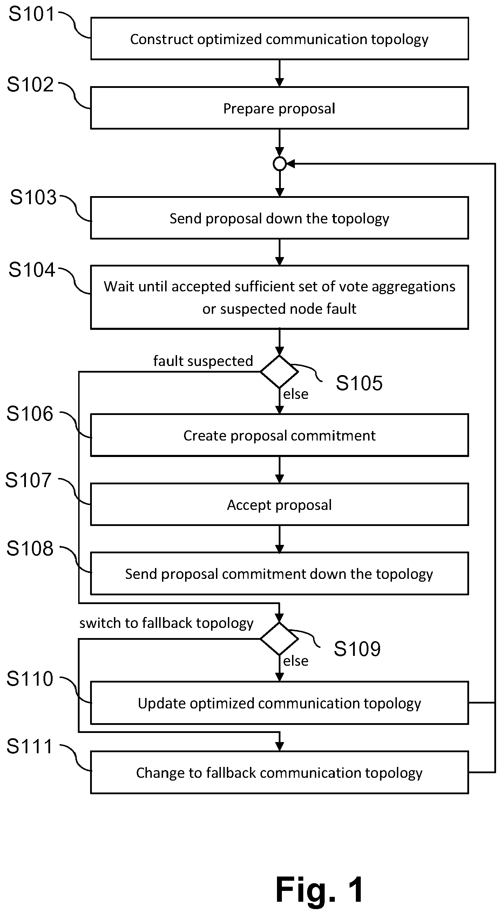

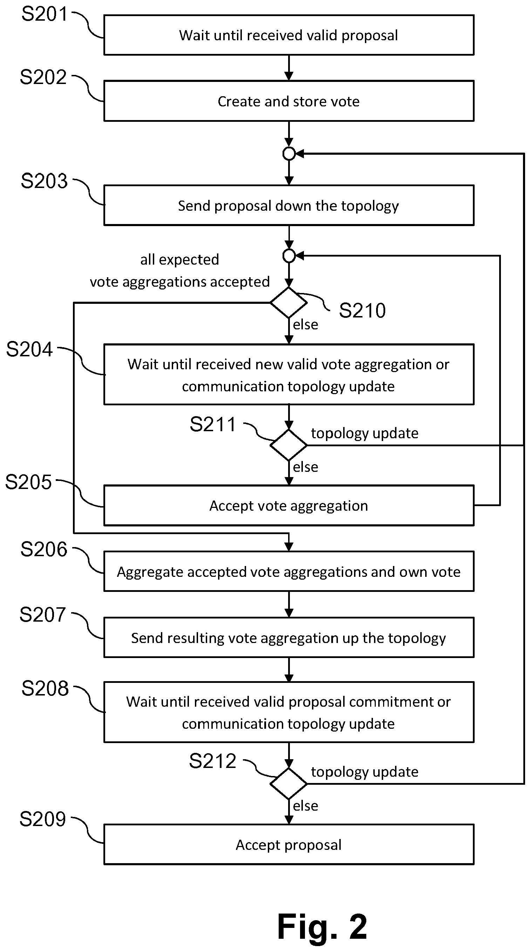

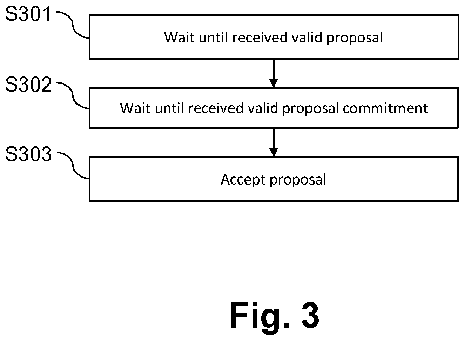

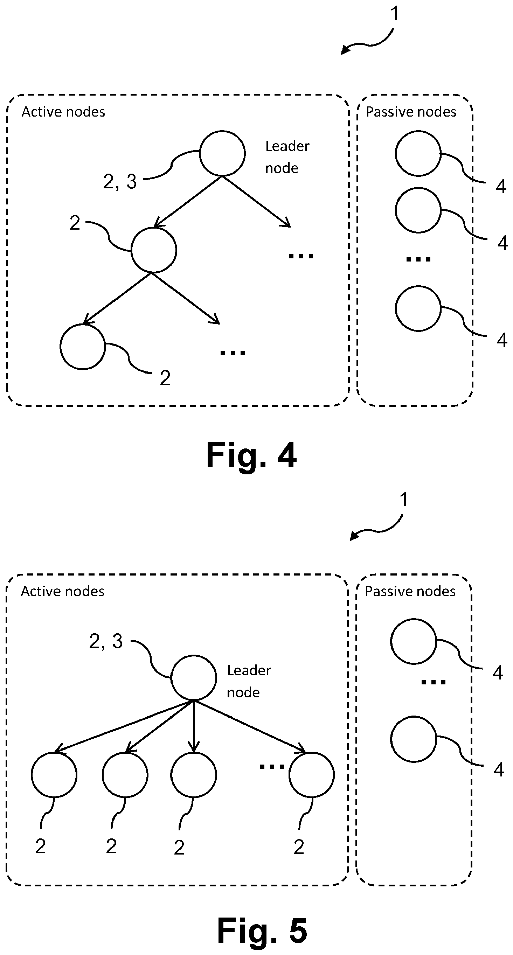

Figs. 1, 2 and 3 are flow diagrams illustrating a processing procedure for establishing consensus between a plurality of distributed nodes according to an embodiment of the invention. The processing executed at a leader node is shown at Fig. 1, while the processing executed at any non-leader active node and at any passive node, respectively, is shown at Fig. 2 and at Fig. 3, respectively. Generally, the procedure may be executed in a network as exemplarily depicted in Fig. 4. According to this embodiment, the network 1 includes a number of nodes in which a subset thereof are active nodes 2. One of the active nodes is selected to be a leader node 3. The remaining nodes are passive nodes 4.

As shown at S101, the leader node 1 constructs an optimized communication topology, according to a predefined algorithm. The optimized communication topology according to of the invention is the one of the network depicted in Fig. 4 having a tree structure. The optimized communication topology is constructed as a first communication topology that is utilized to start a first round of the consensus protocol.

As shown at S102, the leader node 1 prepares a new proposal by binding a new proposal identifier to a proposal payload. It should be noted that binding of the identifier to an expected commitment vote aggregation is *deferred* to a later step (see step S106 below).

As shown at S103, the leader node 1 propagates the proposal down to other nodes 2 according to the communication topology. From the perspective of an active node 2, this corresponds to waiting for a valid proposal, as shown at S201 in Fig. 2. Upon receiving a new proposal, an active node 2 verifies if the proposal should be accepted. If the check fails, the active node 2 does not execute any of the following steps. On the other hand, if the check is successful, the active node 2 produces a vote bound to the proposal identifier, stores the vote in memory, and propagates the proposal down to other nodes according to the topology, as shown at S202 and S203 in Fig. 2.

Next, as shown at S204, the active node 2 waits for receiving valid vote aggregations from other nodes of the topology. When the active node 2 receives a vote aggregation from another active node 2 according to the topology, it verifies if the vote aggregation is valid, then accepts the valid aggregation, as shown at S205. This continues until the active node 2 determines at S210 that it has accepted an expected set of valid aggregations.

Once an active non-leader node 2 has accepted an expected set of valid vote aggregations (possibly none) according to the topology, it further aggregates the collected votes together with its own vote, as shown at S206, then propagates the resulting aggregation up to another active node 2 according to the topology, as shown at S207.

Turning back to Fig. 1, once the leader node 3 has accepted *any* sufficient set of valid vote aggregations at S104 and no active node faults have been determined at S105, the leader node 3 creates a proposal commitment using the vote aggregations at S106 and accepts the proposal at S107. Furthermore, as shown at S108, the leader node 3 propagates the proposal commitment down to other nodes according to the communication topology.

As shown at S208 in Fig. 2, when an active node 2 receives the proposal commitment, it verifies if the included commitment vote aggregation and commitment binding are both valid, then accepts the corresponding proposal at S209.

According to an embodiment of the invention, the leader node 3 may suspect that the topology constructed as the first communication topology may not be reliable to reach consensus due to node faults. Such determination may be made at S105 in Fig. 1. In this case, the leader node 3 constructs an updated second communication topology, different from the first communication topology, as a new optimized communication topology, according to a predefined algorithm, as shown at S110. Then, at least for the changed parts of the topology, the leader node 3 invokes the method execution starting from step S103 using the updated second communication topology and *the same* proposal (unless switching to a fallback topology, as described in further detail below).

In case it is suspected, at S105, that also the second optimized topology may not be reliable to reach consensus due to some pattern of node faults, the leader node 2 may decide at S109 whether to try another optimized communication topology (different from the first and from the second communication topologies) or to construct a *fallback topology.* In the latter case, the leader node 2 invokes the method execution starting from S103 using the fallback topology and *the same* proposal. In a fallback topology, the leader node 3 communicates directly to a number of active *leaf* nodes that is sufficient for collecting enough votes to form a proposal commitment in case of any assumed number of faulty non-leader active nodes. A possible fallback topology is shown in Fig. 5.

Regarding the activity of an active node 2 it can be noted that a topology update decided by the leader node 3 may occur either when the active node 2 waits for receiving new valid vote aggregations, as shown at S204, or when the active node 2 waits for receiving a valid proposal commitment, as shown at S208. In both cases the active node 2 aborts the regular process as described above and continues, as shown at S211 and S212, respectively, with sending the current proposal down the new communication topology, as shown at S203, i.e. at least for the changed parts of the topology.

The activity of a passive node 4 is exemplarily illustrated in Fig. 3. This activity is rather restricted and just includes the steps of waiting for receiving a valid proposal, as shown at S301 in Fig. 3, and waiting for receiving a valid proposal commitment, as shown at S302. If both are successfully received, the passive node 4 accepts the proposal at S303.

In one embodiment, the communication topology resembles a balanced tree, rooted in the leader node, wherein a node of the tree represents a computing node, and an edge of the tree represents a communication path. In case an active node is suspected to be faulty, the tree is updated by replacing the suspected node with a passive node, and moving the node that signaled the potential fault to a leaf position.

In one embodiment, each active node is provided with TEE and executes a trusted application. The leader node utilizes the trusted application to assign (bind) unique identifiers to proposals. In a further embodiment, the proposal identifiers are obtained from a monotonic counter.

In a further embodiment, active nodes utilize the trusted application to produce their votes for a valid proposal.

In one further embodiment, the votes are represented as binary numerals, called *secret shares.* In one further embodiment, a vote (partial) aggregation is obtained with bitwise XOR operation on the corresponding secret shares. In another further embodiment, a vote (partial) aggregation is obtained with a cryptographic hash function applied to a concatenation of the corresponding secret shares and/or vote aggregations.

In a further embodiment, a secret share is randomly generated for each non-leader active node and proposal identifier by the trusted application. In another further embodiment, a secret share is derived by the trusted application with a key derivation function from a secret key value using the corresponding proposal identifier. In one further embodiment, the secret key is generated for each non-leader active node by the trusted application. In another further embodiment, the secret key of each non-leader active node is itself derived by the trusted application with a key derivation function from a common secret key which is generated by the trusted application. In another further embodiment, the two-step key derivation is combined into a single-step key derivation.

In another further embodiment, the votes and vote aggregations are represented as digital signatures or message authentication codes produced by the trusted application over at least parts of the corresponding proposal.

In a further embodiment, the nodes utilize the trusted application to verify if a vote aggregation is valid. In a further embodiment, the nodes utilize the trusted application to certify a valid vote aggregation so that such certificate can be verified by a computing device that is not provided with TEE. Such *vote aggregation certificate* produced by the leader node acts as a binding of the proposal identifier to the aggregation. In a further embodiment, the vote aggregation certificate is represented as a digital signature or a message authentication code produced by the trusted application over at least parts of the corresponding proposal. In a further embodiment, the vote aggregation certificate signature or message authentication code also covers a cryptographic digest of the corresponding vote aggregation.

Many modifications and other embodiments of the invention set forth herein will come to mind to the one skilled in the art to which the invention pertains having the benefit of the teachings presented in the foregoing description and the associated drawings. Therefore, it is to be understood that the invention is not to be limited to the specific embodiments disclosed and that modifications and other embodiments are intended to be included within the scope of the appended claims. Although specific terms are employed herein, they are used in a generic and descriptive sense only and not for purposes of limitation.

## Claims

1. A method for establishing consensus between a plurality of distributed nodes connected via a data communication network (1), the plurality of distributed nodes including a plurality of active nodes (2), the plurality of active nodes (2) including a leader node (3), each of the plurality of distributed nodes including a processor and computer readable media, the method comprising executing, by the leader node (3), the following steps:
preparing a proposal (S102);
constructing a first communication topology by organizing the plurality of active nodes (2) into a tree structure, rooted in the leader node (3);
propagating the proposal to active nodes (2) according to the first communication topology (S103); and
in case of receiving any sufficient set of vote aggregations from the active nodes (2), creating a proposal commitment (106) using the vote aggregations and accepting the proposal (S107), or
in case of suspecting that the first communication topology is not reliable to reach consensus on the proposal due to active node (2) faults, creating an updated communication topology different from the first communication topology (S110), propagating the same proposal down to active nodes (2) according to the updated communication topology (103), and deferring a creation of a commitment binding that includes binding of a proposal to an aggregation of votes of active nodes (2) until after the leader node (3) has aggregated any sufficient quorum of votes to reach consensus on the proposal.

2. The method according to claim 1, further comprising:
constructing, by the leader node (3) after having determined that one or more of the updated communication topologies are not reliable to reach consensus on the proposal due to active node (2) faults, a fallback communication topology, and
continuing with propagating the same proposal down to active nodes (2) according to the fallback communication topology (S111).

3. The method according to claim 2, wherein the fallback communication topology includes a number of active nodes (2) being active leaf nodes, and
wherein the leader node (3), when utilizing the fallback topology, communicates directly to a number of the active leaf nodes that is sufficient for collecting enough votes to form a proposal commitment in case of any assumed number of faulty non-leader active nodes (2).

4. The method according to any of claims 1 to 3, wherein a proposal commitment includes a commitment binding together with the corresponding commitment vote aggregation.

5. The method according to any of claims 1 to 4, further comprising:
receiving, by an active node (2), a proposal commitment;
verifying, by the active node (2), the commitment vote aggregation and the commitment binding of the proposal commitment; and
accepting, by the active node (2), the respective proposal in case the verifying step determined that both the commitment vote aggregation and the commitment binding are valid.

6. The method according to any of claims 1 to 5, wherein constructing the first communication topology, any of the updated communication topologies and/or the fallback communication topology comprises organizing, by the leader node (3), the plurality of active nodes (2) into the tree structure, rooted in the leader node (3).

7. The method according to any of claims 1 to 6, wherein creating any of the updated communication topologies comprises updating the tree structure of a respective previous updated communication topology by replacing suspected active nodes (2) of the respective previous updated communication topology with passive nodes (4) and moving the node that signaled the potential fault to a leaf position.

8. The method according to any of claims 1 to 7, wherein the leader node (3) utilizes a trusted application executed within a trusted execution environment, TEE, of the leader node (3) to bind proposal identifiers to proposal payloads.

9. The method according to any of claims 1 to 8 further comprising:
executing, by an active node (2), a trusted application running in a trusted execution environment, TEE, of the active node (2), and
utilizing, by the active node (2), the trusted application to produce the active node's (2) vote for a valid proposal.

10. The method according to any of claims 1 to 9, wherein votes are represented as binary numerals utilized as secret shares.

11. The method according to claim 10, wherein a vote aggregation or a vote partial aggregation is obtained by applying bitwise XOR operation on the corresponding secret shares, and/or
wherein a vote aggregation or a vote partial aggregation is obtained by applying a cryptographic hash function to a concatenation of the corresponding secret shares.

12. The method according to claim 10 or 11, wherein a secret share is randomly generated for each non-leader active node (2) and proposal identifier by a trusted application, and/or
wherein a secret share is derived by the trusted application with a key derivation function from a secret key value using the corresponding proposal identifier.

13. The method according to any of claims 1 to 12, wherein votes and/or vote aggregations are represented as digital signatures or message authentication codes produced by a trusted application over at least parts of the corresponding proposal.

14. A computer readable medium comprising instructions for carrying out a method for establishing consensus between a plurality of distributed nodes connected via a data communication network (1), the plurality of distributed nodes including a plurality of active nodes (2), the plurality of active nodes (2) including a leader node (3), each of the plurality of distributed nodes including a processor and computer readable media, the method comprising:
preparing a proposal (S102);
constructing a first communication topology (S103) by organizing the plurality of active nodes (2) into a tree structure, rooted in the leader node (3);
propagating the proposal to active nodes (2) according to the first communication topology; and
in case of accepting any sufficient set of vote aggregations from the active nodes (2), creating a proposal commitment (S106) using the vote aggregations and accepting the proposal (S107), or
in case of suspecting that the first communication topology is not reliable to reach consensus on the proposal due to active node (2) faults, creating an updated communication topology different from the first communication topology (S110), propagating the same proposal down to active nodes (2) according to the updated communication topology (S103) and deferring a creation of a commitment binding that includes binding of a proposal to an aggregation of votes of active nodes (2) until after the leader node (3) has aggregated any sufficient quorum of votes to reach consensus on the proposal.

## Patentansprüche

1. Verfahren zum Herstellen eines Konsenses zwischen einer Vielzahl von verteilten Knoten, die über ein Datenkommunikationsnetz (1) verbunden sind, wobei die Vielzahl von verteilten Knoten eine Vielzahl von aktiven Knoten (2) umfasst, wobei die Vielzahl von aktiven Knoten (2) einen Führungsknoten (3) umfasst, wobei jeder der Vielzahl von verteilten Knoten einen Prozessor und computerlesbare Medien umfasst, wobei das Verfahren das Ausführen der folgenden Schritte durch den Führungsknoten (3) umfasst:
Erstellen eines Vorschlags (S102);
Konstruieren einer ersten Kommunikationstopologie durch Organisieren der Vielzahl aktiver Knoten (2) in einer Baumstruktur, die in dem Führungsknoten (3) wurzelt;
Weitergabe des Vorschlags an aktive Knoten (2) entsprechend der ersten Kommunikationstopologie (S103); und
falls ein ausreichender Satz von Stimmenaggregationen von den aktiven Knoten (2) akzeptiert wird, Erstellen einer Vorschlags-Commitments (106) unter Verwendung der Stimmenaggregationen und Akzeptieren des Vorschlags (S107), oder
falls der Verdacht besteht, dass die erste Kommunikationstopologie nicht zuverlässig ist, um einen Konsens über den Vorschlag aufgrund von Fehlern der aktiven Knoten (2) zu erreichen, Erzeugen einer aktualisierten Kommunikationstopologie, die sich von der ersten Kommunikationstopologie unterscheidet (S110), Weitergabe desselben Vorschlags an die aktiven Knoten (2) gemäß der aktualisierten Kommunikationstopologie (103) und Aufschieben der Erzeugung einer Commitment-Bindung, die die Bindung eines Vorschlags an eine Ansammlung von Stimmen der aktiven Knoten (2) umfasst, bis der Führungsknoten (3) ein ausreichendes Quorum von Stimmen angesammelt hat, um einen Konsens über den Vorschlag zu erreichen.

2. Verfahren nach Anspruch 1, weiterhin umfassend:
Konstruieren einer Ausweich-Kommunikationstopologie durch den Führungsknoten (3), nachdem festgestellt wurde, dass eine oder mehrere der aktualisierten Kommunikationstopologien nicht zuverlässig sind, um einen Konsens über den Vorschlag aufgrund von Fehlern der aktiven Knotens (2) zu erreichen, und
Fortsetzen der Weitergabe desselben Vorschlags an die aktiven Knoten (2) entsprechend der Ausweich-Kommunikationstopologie (S111).

3. Verfahren nach Anspruch 2, wobei die Ausweich-Kommunikationstopologie eine Anzahl von aktiven Knoten (2) umfasst, die aktive Blattknoten sind, und
wobei der Führungsknoten (3), wenn er die Ausweichtopologie verwendet, direkt mit einer Anzahl der aktiven Blattknoten kommuniziert, die ausreicht, um genügend Stimmen zu sammeln, um ein Vorschlags-Commitment im Falle irgendeiner angenommenen Anzahl fehlerhafter nicht-führender aktiver Knoten (2) zu bilden.

4. Verfahren nach einem der Ansprüche 1 bis 3, wobei ein Vorschlags-Commitment eine Commitment-Bindung zusammen mit der entsprechenden Commitment-Stimmenaggregation umfasst.

5. Verfahren nach einem der Ansprüche 1 bis 4, weiterhin umfassend:
Empfangen, durch einen aktiven Knoten (2), eines Vorschlags-Commitments;
Verifizieren der Commitment-Stimmenaggregation und der Commitment-Bindung des Vorschlags-Commitments durch den aktiven Knoten (2); und
Akzeptieren des jeweiligen Vorschlags durch den aktiven Knoten (2), falls der Verifizierungsschritt festgestellt hat, dass sowohl die Commitment-Stimmenaggregation als auch die Commitment-Bindung gültig sind.

6. Verfahren nach einem der Ansprüche 1 bis 5, wobei das Konstruieren der ersten Kommunikationstopologie, einer der aktualisierten Kommunikationstopologien und/oder der Ausweich-Kommunikationstopologie das Organisieren der Vielzahl von aktiven Knoten (2) durch den Führungsknoten (3) in die Baumstruktur umfasst, welche in dem Führungsknoten (3) wurzelt.

7. Verfahren nach einem der Ansprüche 1 bis 6, wobei das Erzeugen einer der aktualisierten Kommunikationstopologien das Aktualisieren der Baumstruktur einer jeweiligen vorherigen aktualisierten Kommunikationstopologie umfasst, indem verdächtige aktive Knoten (2) der jeweiligen vorherigen aktualisierten Kommunikationstopologie durch passive Knoten (4) ersetzt werden und der Knoten, der den potenziellen Fehler signalisiert hat, in eine Blattposition verschoben wird.

8. Verfahren nach einem der Ansprüche 1 bis 7, wobei der Führungsknoten (3) eine vertrauenswürdige Anwendung verwendet, die in einer vertrauenswürdigen Ausführungsumgebung (TEE) des Führungsknotens (3) ausgeführt wird, um Vorschlagsidentifikatoren an Vorschlagsnutzdaten zu binden.

9. Verfahren nach einem der Ansprüche 1 bis 8, weiterhin umfassend:
Ausführen einer vertrauenswürdigen Anwendung durch einen aktiven Knoten (2), die in einer vertrauenswürdigen Ausführungsumgebung, TEE, des aktiven Knotens (2) läuft, und
Verwenden der vertrauenswürdigen Anwendung durch den aktiven Knoten (2), um die Stimme des aktiven Knotens (2) für einen gültigen Vorschlag zu erzeugen.

10. Verfahren nach einem der Ansprüche 1 bis 9, wobei die Stimmen als binäre Zahlen dargestellt werden, die als geheime Anteile verwendet werden.

11. Verfahren nach Anspruch 10, wobei eine Stimmenaggregation oder eine Teilaggregation von Stimmen durch Anwendung einer bitweisen XOR-Operation auf die entsprechenden geheimen Anteile erhalten wird, und/oder
wobei eine Stimmenaggregation oder eine Teilaggregation von Stimmen durch Anwendung einer kryptographischen Hash-Funktion auf eine Verkettung der entsprechenden geheimen Anteile erhalten wird.

12. Verfahren nach Anspruch 10 oder 11, wobei ein geheimer Anteil für jeden nicht führenden aktiven Knoten (2) und Vorschlagsidentifikator durch eine vertrauenswürdige Anwendung zufällig erzeugt wird, und/oder
wobei ein geheimer Anteil durch die vertrauenswürdige Anwendung mit einer Schlüsselableitungsfunktion aus einem geheimen Schlüsselwert unter Verwendung des entsprechenden Vorschlagsidentifikators abgeleitet wird.

13. Verfahren nach einem der Ansprüche 1 bis 12, wobei Stimmen und/oder Stimmenaggregationen als digitale Signaturen oder Nachrichtenauthentifizierungscodes dargestellt werden, die von einer vertrauenswürdigen Anwendung über zumindest Teile des entsprechenden Vorschlags erzeugt werden.

14. Computerlesbares Medium, das Anweisungen zum Ausführen eines Verfahrens zum Herstellen eines Konsenses zwischen einer Vielzahl von verteilten Knoten, die über ein Datenkommunikationsnetz (1) verbunden sind, umfasst, wobei die Vielzahl von verteilten Knoten eine Vielzahl von aktiven Knoten (2) umfasst, wobei die Vielzahl von aktiven Knoten (2) einen Führungsknoten (3) umfasst, wobei jeder der Vielzahl von verteilten Knoten einen Prozessor und computerlesbare Medien umfasst, wobei das Verfahren umfasst:
Erstellen eines Vorschlags (S102);
Konstruieren einer ersten Kommunikationstopologie (S103) durch Organisieren der Vielzahl aktiver Knoten (2) in einer Baumstruktur, die in dem Führungsknoten (3) wurzelt;
Weitergabe des Vorschlags an aktive Knoten (2) entsprechend der ersten Kommunikationstopologie; und
falls ein ausreichender Satz von Stimmenaggregationen von den aktiven Knoten (2) akzeptiert wird, Erstellen einer Vorschlags-Commitments (S106) unter Verwendung der Stimmenaggregationen und Akzeptieren des Vorschlags (S107), oder
falls der Verdacht besteht, dass die erste Kommunikationstopologie nicht zuverlässig ist, um einen Konsens über den Vorschlag aufgrund von Fehlern der aktiven Knoten (2) zu erreichen, Erzeugen einer aktualisierten Kommunikationstopologie, die sich von der ersten Kommunikationstopologie unterscheidet (S110), Weitergabe desselben Vorschlags an die aktiven Knoten (2) gemäß der aktualisierten Kommunikationstopologie (S103) und Aufschieben der Erzeugung einer Commitment-Bindung, die die Bindung eines Vorschlags an eine Ansammlung von Stimmen der aktiven Knoten (2) umfasst, bis der Führungsknoten (3) ein ausreichendes Quorum von Stimmen angesammelt hat, um einen Konsens über den Vorschlag zu erreichen.

## Revendications

1. Procédé pour établir un consensus entre une pluralité de noeuds répartis reliés via un réseau de communication de données (1), la pluralité de noeuds répartis comportant une pluralité de noeuds actifs (2), la pluralité de noeuds actifs (2) comportant un noeud leader (3), chacun parmi la pluralité de noeuds répartis comportant un processeur et un support lisible par ordinateur, le procédé comprenant l'exécution, par le noeud leader (3), des étapes suivantes :
la préparation d'une proposition (S102) ;
la construction d'une première topologie de communication par l'organisation de la pluralité de noeuds actifs (2) dans une structure arborescente, enracinée dans le noeud leader (3) ;
la propagation de la proposition vers des noeuds actifs (2) en fonction de la première topologie de communication (S103) ; et
en cas de réception d'un ensemble suffisant de cumuls de votes depuis les noeuds actifs (2), la création d'un engagement de proposition (106) en utilisant les cumuls de votes et l'acceptation de la proposition (S107), ou
en cas de soupçon que la première topologie de communication n'est pas fiable pour atteindre un consensus sur la proposition en raison de défauts de noeuds actifs (2), la création d'une topologie de communication mise à jour différente de la première topologie de communication (S110), la propagation de la même proposition vers des noeuds actifs (2) en fonction de la topologie de communication (103) mise à jour, et le report d'une création d'une contrainte d'engagement qui comporte la contrainte d'une proposition à un cumul de votes de noeuds actifs (2) jusqu'après que le noeud leader (3) a cumulé un quorum suffisant de votes pour atteindre un consensus sur la proposition.

2. Procédé selon la revendication 1, comprenant en outre les étapes consistant en :
la construction, par le noeud leader (3) après avoir déterminé qu'une ou plusieurs des topologies de communication mises à jour ne sont pas fiables pour atteindre un consensus sur la proposition en raison de défauts de noeuds actifs (2), d'une topologie de communication de repli, et
la poursuite de la propagation de la même proposition vers des noeuds actifs (2) en fonction de la topologie de communication de repli (5111).

3. Procédé selon la revendication 2, dans lequel la topologie de communication de repli comporte un nombre de noeuds actifs (2) qui sont des noeuds feuilles actifs, et
dans lequel le noeud leader (3), lors de l'utilisation de la topologie de repli, communique directement avec un nombre des noeuds feuilles actifs qui est suffisant pour recueillir suffisamment de votes pour former un engagement de proposition en cas de n'importe quel nombre supposé de noeuds actifs non leaders (2) défaillants.

4. Procédé selon l'une quelconque des revendications 1 à 3, dans lequel un engagement de proposition comporte une contrainte d'engagement avec le cumul de votes d'engagement correspondant.

5. Procédé selon l'une quelconque des revendications 1 à 4, comprenant en outre les étapes consistant en :
la réception, par un noeud actif (2), d'un engagement de proposition ;
la vérification, par le noeud actif (2), du cumul de votes d'engagement et de la contrainte d'engagement de l'engagement de proposition ; et
l'acceptation, par le noeud actif (2), de la proposition respective dans le cas où l'étape de vérification a déterminé que le cumul de votes d'engagement et la contrainte d'engagement sont tous les deux valables.

6. Procédé selon l'une quelconque des revendications 1 à 5, dans lequel la construction de la première topologie de communication, de l'une quelconque des topologies de communication mises à jour et/ou de la topologie de communication de repli comprend l'organisation, par le noeud leader (3), de la pluralité de noeuds actifs (2) dans la structure arborescente, enracinée dans le noeud leader (3).

7. Procédé selon l'une quelconque des revendications 1 à 6, dans lequel la création de l'une quelconque des topologies de communication mises à jour comprend la mise à jour de la structure arborescente d'une topologie de communication mise à jour précédente respective par le remplacement de noeuds actifs (2) soupçonnés de la topologie de communication mise à jour précédente respective par des noeuds passifs (4) et le déplacement du noeud ayant signalé le défaut potentiel à une position de feuille.

8. Procédé selon l'une quelconque des revendications 1 à 7, dans lequel le noeud leader (3) utilise une application de confiance exécutée à l'intérieur d'un environnement d'exécution de confiance, TEE, du noeud leader (3) pour contraindre des identifiants de proposition à des charges utiles de proposition.

9. Procédé selon l'une quelconque des revendications 1 à 8, comprenant en outre les étapes consistant en :
l'exécution, par un noeud actif (2), d'une application de confiance fonctionnant dans un environnement d'exécution de confiance, TEE, du noeud actif (2), et
l'utilisation, par le noeud actif (2), de l'application de confiance pour produire le vote du noeud actif (2) pour une proposition valable.

10. Procédé selon l'une quelconque des revendications 1 à 9, dans lequel des votes sont représentés en tant que numéros binaires utilisés en tant que parts secrètes.

11. Procédé selon la revendication 10, dans lequel un cumul de votes ou un cumul partiel de votes est obtenu par l'application d'une opération OU exclusif binaire sur les parts secrètes correspondantes, et/ou
dans lequel un cumul de votes ou un cumul partiel de votes est obtenu par l'application d'une fonction de hachage cryptographique à une concaténation des parts secrètes correspondantes.

12. Procédé selon la revendication 10 ou 11, dans lequel une part secrète est générée aléatoirement pour chaque noeud actif non leader (2) et chaque identifiant de proposition par une application de confiance, et/ou
dans lequel une part secrète est dérivée par l'application de confiance avec une fonction de dérivation de clé à partir d'une valeur de clé secrète en utilisant l'identifiant de proposition correspondant.

13. Procédé selon l'une quelconque des revendications 1 à 12, dans lequel des votes et/ou des cumuls de votes sont représentés en tant que signatures numériques ou codes d'authentification de message produits par une application de confiance sur au moins des parties de la proposition correspondante.

14. Support lisible par ordinateur comprenant des instructions pour réaliser un procédé pour établir un consensus entre une pluralité de noeuds répartis reliés via un réseau de communication de données (1), la pluralité de noeuds répartis comportant une pluralité de noeuds actifs (2), la pluralité de noeuds actifs (2) comportant un noeud leader (3), chacun parmi la pluralité de noeuds répartis comportant un processeur et un support lisible par ordinateur, le procédé comprenant les étapes consistant en :
la préparation d'une proposition (S102) ;
la construction d'une première topologie de communication (S103) par l'organisation de la pluralité de noeuds actifs (2) dans une structure arborescente, enracinée dans le noeud leader (3) ;
la propagation de la proposition vers des noeuds actifs (2) en fonction de la première topologie de communication ; et
en cas d'acceptation d'un ensemble suffisant de cumuls de votes depuis les noeuds actifs (2), la création d'un engagement de proposition (S106) en utilisant les cumuls de votes et l'acceptation de la proposition (S107), ou
en cas de soupçon que la première topologie de communication n'est pas fiable pour atteindre un consensus sur la proposition en raison de défauts de noeuds actifs (2), la création d'une topologie de communication mise à jour différente de la première topologie de communication (S110), la propagation de la même proposition vers des noeuds actifs (2) en fonction de la topologie de communication (S103) mise à jour, et le report d'une création d'une contrainte d'engagement qui comporte la contrainte d'une proposition à un cumul de votes de noeuds actifs (2) jusqu'après que le noeud leader (3) a cumulé un quorum suffisant de votes pour atteindre un consensus sur la proposition.
